# EUROPEAN PATENT APPLICATION

(11) **EP 1 832 669 A1**
(43) Date of publication of application: **12.09.2007**
(21) Application number: 07103364.1
(22) Date of filing: 02.03.2007
(51) Int. Cl.: C23C 14/14, C23C 14/34, C23C 28/00, F01D 5/28

(54) **Bond coat process for thermal barrier coating.**

(30) Priority: 06.03.2006 US 368824
(71) Applicant: General Electric Company, Schenectady, NY 12345 (US)
(72) Inventor: Zimmerman, Jr., Robert George, Morrow, OH 45152 (US); Evans, John Douglas, Springfield, OH 45502 (US); Viguie, Rudolfo, Crestview Hills, KY 41047 (US)
(74) Representative: Bedford, Grant Richard

(57) **Abstract**

Methods provide for depositing a bond coat (34) of a thermal barrier coating (TBC) system (30) for a component designed for use in a hostile thermal environment. The method includes providing an article substrate (32) having a substrate surface, forming a bond coat on the substrate by depositing a beta-phase Ni-Al bond coat by cathodic arc deposition, processing the bond coat by peening to improve the coating structure, and heat treating the bond coat. Also disclosed is a turbine blade (20) comprising a nickel-base superalloy substrate, a bond coat on the surface of the substrate, and a ceramic thermal barrier coating (30) overlying the bond coat surface.

## Description

The present application relates generally to a process for applying coatings of the type used to protect components exposed to high temperature environments, such as bond coats for protecting the surface of nickel-base superalloys. The present application also relates to forming a protective coating by depositing a Ni-Al based bond coat by cathodic arc deposition on the surface of an aircraft engine component. Another aspect of the present application relates to a coated turbine blade.

Higher operating temperatures for gas turbine engines are continuously sought in order to increase their efficiency. However, as operating temperatures increase, the high temperature durability of the components of the engine must correspondingly increase. Significant advances in high-temperature capabilities have been achieved through the formulation of nickel- and cobalt-base superalloys. Nonetheless, when used to form components of the turbine, combustor and augmentor sections of a gas turbine engine, such alloys alone are often susceptible to damage by oxidation and hot corrosion attack and may not retain adequate mechanical properties. For this reason, these components are often protected by an environmental and/or thermal-insulating coating, the latter of which is termed a thermal barrier coating (TBC) system. Ceramic materials and particularly yttria-stabilized zirconia (YSZ) are widely used as a thermal barrier coating (TBC), or topcoat, of TBC systems used on gas turbine engine components. The TBC employed in the highest-temperature regions of gas turbine engines is typically deposited by electron beam physical vapor deposition (EBPVD) techniques that yield a columnar grain structure that is able to expand and contract without causing damaging stresses that lead to spallation.

To be effective, TBC systems must have low thermal conductivity, strongly adhere to the article, and remain adherent throughout many heating and cooling cycles. The latter requirement is particularly demanding due to the different coefficients of thermal expansion between ceramic topcoat materials and the superalloy substrates they protect. To promote adhesion and extend the service life of a TBC system, an oxidation-resistant bond coat is usually employed. Bond coats are typically in the form of overlay coatings such as MCrAlX (where M is iron, cobalt, and/or nickel, and X is yttrium or another rare earth element), or diffusion aluminide coatings.

While bond coats deposited by various techniques have been successfully employed, there remains a need for a bond coat for thermal barrier coatings that can be applied to aircraft engine components with a low cost process, while at the same exhibiting low porosity and oxidation.

In one embodiment, the present invention generally provides a process for forming a Ni-Al base bond coat on a component designed for use in a hostile thermal environment, such as a superalloy turbine component of a gas turbine engine.

In another embodiment, the present invention is directed to a method for forming a protective bond coating on a substrate. The method comprises the steps of providing an article substrate having a substrate surface, forming a bond coat on the substrate by depositing a beta-phase Ni-Al bond coat by cathodic arc deposition, processing the bond coat by peening to improve the coating structure, and heat treating the bond coat to a preselected temperature for a preselected period of time in a vacuum.

In another embodiment, the present invention is directed to a method for forming a thermal barrier coating system. The method comprises the steps of providing a nickel-base superalloy article substrate comprising a component of a gas turbine engine and having a substrate surface, forming a bond coat on the substrate by depositing a NiAlCrZr layer by cathodic arc deposition, processing the bond coat by peening to improve the coating structure, heat treating the bond coat in a vacuum at a temperature of from about 1975 °F to about 2000 °F for a duration of from about 2 hours to about 4 hours, and depositing a ceramic thermal barrier coating overlying the bond coat surface.

In yet another embodiment, the present invention is directed to a turbine blade. The turbine blade comprises a nickel-base superalloy substrate, a bond coat on the surface of the substrate, and a ceramic thermal barrier coating overlying the bond coat surface. The bond coating is formed by depositing a NiAlCrZr layer by cathodic arc deposition on the surface of the substrate, processing the bond coat by peening to improve the coating structure, and heat treating the bond coat in a vacuum at a temperature of from about 1975 °F to about 2000 °F for a duration of from about 2 hours to about 4 hours.

Various features, aspects and advantages of embodiments of the present invention will become evident to those skilled in the art from a reading of the present disclosure.

While the specification concludes with claims particularly pointing out and distinctly claiming the invention, it is believed that the present invention will be better understood from the following description in conjunction with the accompanying figures, in which like reference numerals identify like elements, and wherein:
FIG. 1 is a perspective view of a turbine blade;
FIG. 2 is a schematic view of a thermal barrier coating system having a bond coat deposited in accordance with one embodiment of the present invention;
FIG. 3 is a process flow chart illustrating the method of applying the coatings in accordance with one embodiment the present invention; and
FIGS. 4 and 5 are scanned images of cathodic arc deposited bond coats, FIG. 4 showing the condition of the bond coat that had not undergone peening and heat treatment prior to testing and FIG. 5 showing the condition of the bond coat that had previously undergone peening and heat treatment in accordance with one embodiment of the present invention.

In one embodiment, the present invention is generally applicable to metal components that are protected from a thermally hostile environment by a thermal barrier coating (TBC) system. Notable examples of such components include the high and low pressure turbine nozzles (vanes) and buckets (blades), shrouds, combustor liners, transition pieces and augmentor hardware of gas turbine engines. While embodiments of this invention are particularly applicable to turbine engine components, the teachings of this invention are generally applicable to any component on which a thermal barrier may be used to thermally insulate the component from its environment.

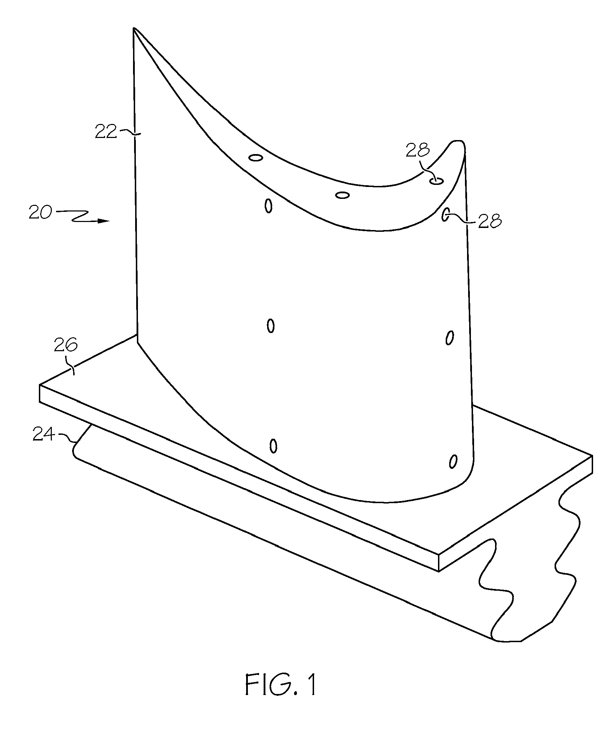

FIG. 1 depicts a component article of a gas turbine engine such as a turbine blade or turbine vane. The turbine blade 20 is formed of any operable material, but in one embodiment is a nickel-base superalloy. The turbine blade 20 includes an airfoil section 22 against which the flow of hot exhaust gas is directed. The turbine blade 20 is mounted to a turbine disk (not shown) by a dovetail 24 which extends downwardly from the airfoil 22 and engages a slot on the turbine disk. A platform 26 extends longitudinally outwardly from the area where the airfoil 22 is joined to the dovetail 24. A number of internal passages extend through the interior of the airfoil 22, ending in openings 28 in the surface of the airfoil 22. During service, a flow of cooling air is directed through the internal passages to reduce the temperature of the airfoil 22.

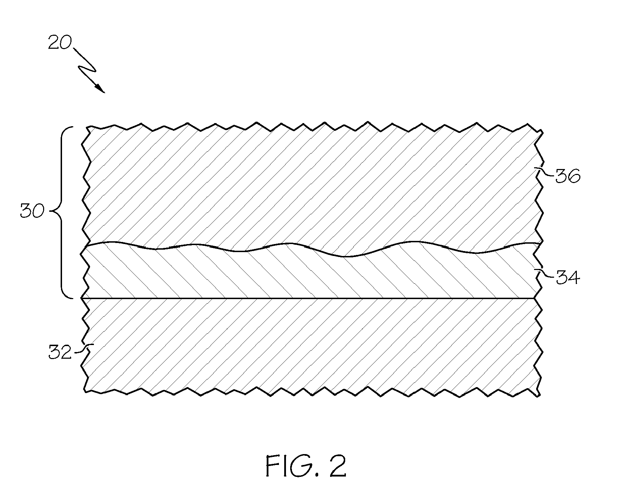

Referring now to FIG. 2, there is shown a partial cross-section of a turbine engine component 20 having a thermal barrier coating (TBC) system 30 in accordance with the present invention. As shown, the coating system 30 includes a thermal-insulating ceramic layer 36 bonded to a substrate 32 (blade 20) with a bond coat 34.

The component article and hence the substrate 32 may comprise any of a variety of metals or metal alloys, including those based on nickel, cobalt and/or iron alloys or superalloys. In one embodiment, substrate 32 is made of a nickel-base alloy, and in another embodiment substrate 32 is made of a nickel-base superalloy. A nickel-base alloy has more nickel than any other element. The nickel-base superalloy can be strengthened by the precipitation of gamma prime or a related phase. In one example, the nickel-base superalloy has a composition, in weight percent, of from about 4 to about 20 percent cobalt, from about 1 to about 10 percent chromium, from about 5 to about 7 percent aluminum, from about 0 to about 2 percent molybdenum, from about 3 to about 8 percent tungsten, from about 4 to about 12 percent tantalum, from about 0 to about 2 percent titanium, from about 0 to about 8 percent rhenium, from about 0 to about 6 percent ruthenium, from about 0 to about 1 percent niobium, from about 0 to about 0.1 percent carbon, from about 0 to about 0.01 percent boron, from about 0 to about 0.1 percent yttrium, from about 0 to about 1.5 percent hafnium, balance nickel and incidental impurities.

For example, a nickel-base superalloy of interest is available by the trade name Rene N5, which has a nominal composition, by weight of 7.5% cobalt, 7% chromium, 1.5% molybdenum, 6.5% tantalum, 6.2% aluminum, 5% tungsten, 3% rhenium, 0.15% hafnium, 0.004% boron, and 0.05% carbon, with the balance nickel and minor impurities.

In accordance with one embodiment of the present invention, the bond coat 34 is predominantly of the beta (β) NiAl phase, with limited alloying additions. In one embodiment, the NiAl bond coat has an aluminum content of from about 17 to about 25 weight percent and in another embodiment, from about 18 to about 21 weight percent aluminum, balance being essentially nickel. The bond coat 34 may also contain one or more reactive elements, for example, zirconium and/or chromium, such as in the amount of from about 0.8 to about 1.2 weight percent zirconium and from about 5 to about 7 weight percent chromium, and in another embodiment, in an amount of from about 0.9 to about 1.1 weight percent zirconium and from about 5.5 to about 6.5 weight percent chromium.

According to commonly assigned U.S. Pat. No. 6,291,084 to Darolia et al., the presence of chromium in a beta-NiAl overlay coating has a significant effect on the spallation resistance of the ceramic layer 36 adhered to the NiAl bond coat 34 as a result of solid solution strengthening by chromium and precipitation strengthening from fine Î±-Cr phases dispersed within the beta phase of the coating 34.

In one embodiment, ceramic layer 36 is yttria-stabilized zirconia (YSZ), with a suitable composition being about 3 to about 10 weight percent yttria, though other ceramic materials could be used, such as yttria, nonstabilized zirconia, or zirconia stabilized by other oxides, such as magnesia (MgO), ceria (CeO₂), scandia (Sc₂O₃) or alumina (Al₂O₃). The ceramic layer 36 is deposited to a thickness that is sufficient to provide the required thermal protection for the underlying substrate, generally on the order of from about 75 to about 350 microns. As with prior art TBC systems, the surface of the bond coat 34 oxidizes to form an oxide surface layer (scale) to which the ceramic layer 36 chemically bonds.

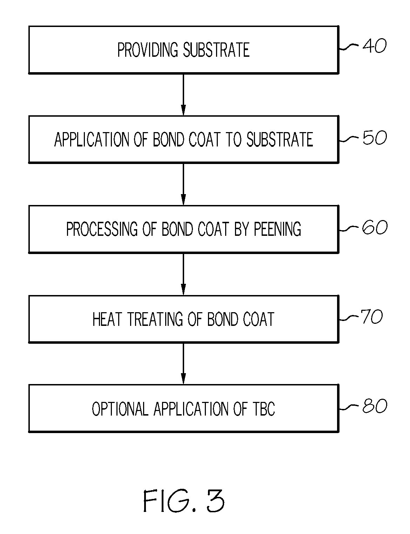

Referring now to FIG. 3 there is shown a flow chart of the method for fabricating an article in accordance with the present invention. In a first step 40, an article and thence the substrate 32 are provided. In one embodiment, the article is a component of a gas turbine engine such as a gas turbine blade 20 or vane (or "nozzle", as the vane is sometimes called), see FIG. 1. In a second step 50, a bond coat 34 is formed on the surface of the substrate 32. The bond coat 34 is deposited using a cathodic arc PVD process, wherein a metal vapor arc at the cathode surface ionizes the cathode material. Metallic ions move away from the cathode surface and are deposited onto articles to be coated. A negative bias potential can be applied to attract and accelerate ion collection on the coated article. In one embodiment, a thickness for the overlay bond coating 34 is about 37 microns to protect the underlying substrate 32, though thicknesses of from about 25 to about 50 microns are believed to be suitable.

In a third step 60, the bond coat 34 is thereafter processed to achieve improved coating structure, i.e. coating density, by reducing the amount of porosity or voids in the coating. In general, two types of porosity or voiding occur in the coating structure, inter-particle voiding and macro-particle voiding. Inter-particle voiding are voids or defects in the coating structure from prior particle boundaries. Macro-particle voiding are voids or defects in the coating structure due to the presence of large macro particles. In one embodiment, prior to processing, a typical bond coat contains about 5% to about 10% porosity or voids. After processing in accordance with one embodiment of the present invention, the porosity of the bond coat 34 is reduced to less than about 2%.

The processing 60 may be accomplished by shot peening (sometimes termed "peening"). In this technique, the surface of the bond coat 34 is impacted with a flow of shot made of material that is hard relative to the bond coat 34, so that the bond coat 34 is deformed. In one embodiment, ceramic media shot is used. The ceramic media may comprise zirconia (ZrO₂), silica (SiO₂) and alumina (Al₂O₃). For example, a ceramic media of interest is available by the trade name Z850, which has a nominal composition, by weight of from about 60 to 70 weight percent ZrO₂, from about 27 to about 33 weight percent SiO₂ and less than about 10% Al₂O₃. In one example, the ceramic media has a diameter from about 0.008 to about 0.045 inches, and in another embodiment, from about 0.033 to about 0.045 inches. While spherical shaped ceramic media are typically used, media of other shapes may be used, if desired. In another embodiment, conditioned cut wire media is used. The conditioned cut wire media may comprise plain carbon or stainless steel shot. In one example, the conditioned cut wire media has a diameter from about 0.012 to about 0.94 inches.

In one embodiment, the bond coat 34 is peened with a shot material at a peening intensity of from about 9N to about 8A, and in another embodiment, from about 9N to about 12N. If the peening intensity is too low, there is insufficient deformation to reduce the porosity. On the other hand, if the peening intensity is too great, there may be cracking or other damage to the bond coat 34 or to the underlying substrate 32. In one embodiment, coverage is in the range of from about 100% to about 1200%. Coverage describes the amount of surface that is peened. For example, 100% coverage describes once over the entire surface while 1200% describes 12 times over the entire surface of the peened article.

After the processing step 60, a fourth step 70 is performed by heat treating the bond coat 34 to enhance diffusion bonding between the coating structure and the substrate and increase the density of the bond coat 34. In one embodiment, a suitable heat treatment is to subject the bond coat 34 to a temperature of from about 1975°F to about 2000°F for a duration of from about 2 to about 4 hours in a vacuum, in another embodiment to a temperature of about 1975° F for a duration of about four hours in a vacuum, and in yet another embodiment to a temperature of about 2000 °F for a duration of about 2 hours.

Thereafter, an optional fifth step 80 may be performed by depositing a ceramic thermal barrier layer 36 overlying the bond coat 34. The ceramic thermal barrier coating 34 may be deposited by any operable technique, for example, electron beam physical vapor deposition, or plasma spray.

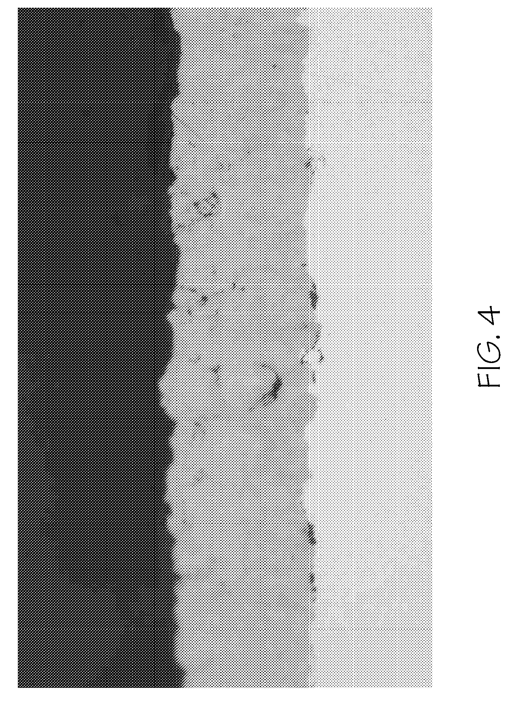

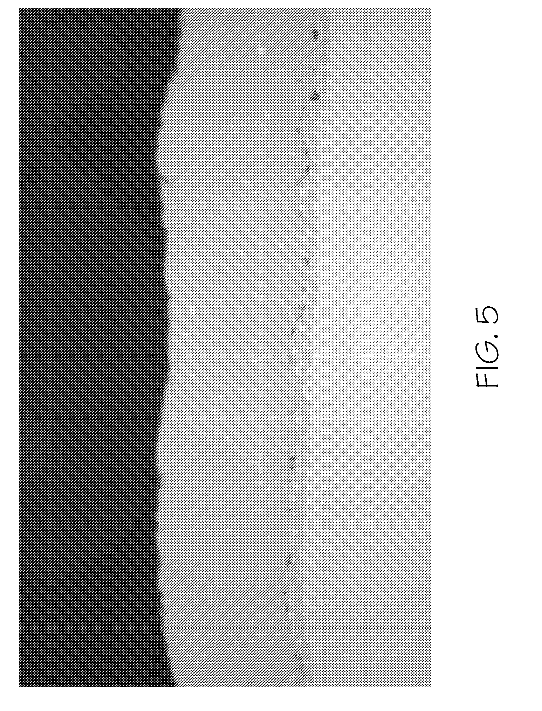

Referring now to FIGS. 4 and 5, there are shown 500x scanned images showing cathodic arc deposited bond coats in accordance with the present invention. FIG. 4 shows the condition of a bond coat that had not undergone peening and heat treatment prior to testing and FIG. 5 shows the condition of a bond coat that had previously undergone peening and heat treatment. The scanned images illustrate the improvement in density and interparticle bonding achieved in accordance with one embodiment of the present invention.

### EXAMPLE

The following example is given solely for the purpose of illustration and is not to be construed as limitations of embodiments of the present invention, as many variations of the invention, as many variations of the invention are possible without departing from the spirit and scope of embodiments of the invention.

In the example, the test samples are turbine blades made from a nickel-base superalloy, available by the trade name Rene N5.

A process of one embodiment of the invention is used to form a protective bond coating by cathodic arc deposition on test samples as shown in FIG. 4 ("Sample A") and FIG. 5 ("Sample B"). The bond coat has the following composition: 30 weight percent aluminum, 6 weight percent chromium, 1 weight percent zirconium, and the balance nickel. The bond coat formed has a thickness of 33 microns. Following deposition, Sample B is peened with Z850 ceramic media at an intensity of 12N, 600% coverage. Thereafter, the bond coat is heated to a temperature of 2000°F for 2 hours. Coating density / porosity for Sample A and B were then measured. The results are provided in Table I:

**TABLE I**

| | Coating Density | Porosity |
|---|---|---|
| Sample A | 95% | 5% |
| Sample B | 99% | 1% |

While particular embodiments of the present invention have been illustrated and described, it would be clear to those skilled in the art that various other changes and modifications can be made without departing from the spirit and scope of the invention. It is therefore intended to cover in the appended claims all such changes and modifications that are within the scope of embodiments of this invention.

### PARTS LIST

- 20: turbine blade
- 22: airfoil section
- 24: dovetail
- 26: platform
- 28: openings
- 30: thermal barrier coating (TBC) system
- 32: substrate
- 34: bond coat
- 36: thermal-insulating ceramic layer

## Claims

1. A method for forming a protective bond coating on a substrate, the method comprising the steps of:
a) providing an article substrate (32) having a substrate surface;
b) forming a bond coat (34) on the substrate by depositing a beta-phase Ni-Al bond coat by cathodic arc deposition;
c) processing the bond coat by peening to improve the coating structure; and
d) heat treating the bond coat to a preselected temperature for a preselected period of time in a vacuum.

2. The method of claim 1, wherein the article substrate comprises a nickel-base superalloy.

3. The method of claim 1 or claim 2, wherein the article substrate comprises a component (20) of a gas turbine engine.

4. The method of any preceding claim, wherein the bond coat further contains chromium and zirconium.

5. The method of any preceding claim, wherein the bond coat comprises a NiAlCrZr bond coat comprising from about 27 weight percent to about 32 weight percent aluminum, from about 5 weight percent to about 7 weight percent chromium, from about 0.8 weight percent to about 1.2 weight percent zirconium, with the balance being essentially nickel.

6. The method of any preceding claim, wherein the bond coat has a thickness of from about 25 microns to about 50 microns.

7. The method of any preceding claim, wherein the peening intensity is from about 9N to about 12N.

8. The method of any preceding claim, wherein the preselected temperature is in the range of from about 1975 °F to about 2000 °F and the preselected time is in the range of from about 2 hours to about 4 hours.

9. The method of any preceding claim, further comprising the step of depositing a ceramic thermal barrier coating (36) overlying the bond coat surface.

10. The method of claim 9, wherein the ceramic thermal barrier coating (36) comprises a yttria-stabilized zirconia having a yttria content of from about 3 percent by weight to about 10 percent by weight of the yttria-stabilized zirconia.
